# EUROPEAN PATENT APPLICATION

(11) **EP 4 716 438 A1**
(43) Date of publication of application: **25.03.2026**
(21) Application number: 24809977.2
(22) Date of filing: 19.02.2024
(51) Int. Cl.: H10K 77/10, H01L 31/04, H10K 30/50

(54) **SUBSTRATE, SOLAR CELL, PHOTOVOLTAIC SYSTEM AND ELECTRICAL DEVICE**

(30) Priority: 24.05.2023 CN 202310589746
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: GUO, Yongsheng, Shanghai 200241 (CN); CHEN, Guodong, Shanghai 200241 (CN)
(74) Representative: Gong, Jinping
(86) International application number: PCT/CN2024/077570
(87) International publication number: WO 2024/239728

(57) **Abstract**

A substrate (1110), a solar cell (1100), a photovoltaic system, and an electric device are provided. The substrate (1110) includes a first film layer (100), where at least one through-hole (110) is provided on the first film layer (100). When the substrate (1110) undergoes bending, the first film layer (100) bends and deforms accordingly. Since the through-hole (110) is provided on the first film layer (100), the through-hole (110) can reduce stress experienced by the first film layer (100) surrounding the through-hole due to bending, thereby improving bending resistance of the first film layer (100), and further improving bending resistance of the substrate (1110). This reduces a risk that the substrate (1110) develops bending marks, fractures, or breaks during repeated bending.

## Description

This application claims priority to Chinese Patent Application No. 202310589746.X, filed on May 24, 2023 and entitled "SUBSTRATE, SOLAR CELL, PHOTOVOLTAIC SYSTEM, AND ELECTRIC DEVICE", which is incorporated herein by reference in its entirety.

### TECHNICAL FIELD

This application relates to the field of solar cell technology and particularly provides a substrate, a solar cell, a photovoltaic system, and an electric device.

### BACKGROUND

In related art, a substrate of a solar cell is usually a plastic substrate. During repeated bending of a flexible component, the substrate develops noticeable bending marks, or faces a risk of damage or fracture. Such damages adversely affect the performance of the substrate.

### SUMMARY

Embodiments of this application are intended to provide a substrate, a solar cell, a photovoltaic system, and an electric device, aiming to address the issue in related art that the substrate is prone to developing bending marks, damage, or fracture due to repeated bending.

Technical solutions adopted in the embodiments of this application are as follows.

According to a first aspect, an embodiment of this application provides a substrate, the substrate includes a first film layer, and the first film layer is provided with at least one through-hole.

Beneficial effects of this embodiment of this application are as follows. In the substrate provided by this embodiment of this application, when the substrate undergoes bending, the first film layer bends and deforms accordingly. Since the through-hole is provided on the first film layer, the through-hole can reduce stress experienced by the first film layer surrounding the through-hole due to bending, thereby improving bending resistance of the first film layer, and further improving bending resistance of the substrate. This reduces the risk that the substrate develops bending marks, fractures, or breaks during repeated bending.

In some embodiments, the first film layer has a bending axis, and the bending axis passes through at least some of the through-holes.

According to the above technical solution, when the substrate undergoes bending, the first film layer bends and deforms around the bending axis. It can be understood that the first film layer exhibits the greatest degree of bending deformation at the bending axis. The bending axis passes through at least some of the through-holes, thereby enabling the through-hole to more effectively reduce stress experienced by the first film layer in a bent state and improve bending resistance.

In some embodiments, the bending axis passes through each of the through-holes.

According to the above technical solution, the through-holes are sequentially arranged along the bending axis. When the substrate undergoes bending, the first film layer bends and deforms around the bending axis. At this time, the through-holes more effectively reduce stress experienced by the first film layer and improve bending resistance.

In some embodiments, at least one through-hole is symmetrically arranged with respect to the bending axis.

According to the above technical solution, the through-holes are sequentially arranged along an extension direction of the bending axis, and at least one through-hole is symmetrically arranged with respect to the bending axis. When the substrate undergoes bending, the first film layer bends and deforms around the bending axis. At this time, the through-holes simultaneously improve bending resistance of portions of the first film layer on both sides of the bending axis, enhancing symmetry of the portions of the first film layer on both sides of the bending axis.

In some embodiments, a width of the through-hole decreases in a direction away from the bending axis.

According to the above technical solution, when the substrate undergoes bending, a first side portion and a second side portion of the first film layer bend and deform around the bending axis. It can be understood that a part of the first side portion and the second side portion farther from the bending axis exhibits a smaller degree of bending. Therefore, the width of the through-hole is configured to decrease in the direction away from the bending axis to adapt to variations in the degrees of bending of the first film layer.

In some embodiments, the first film layer has a bending axis, and the through-hole is provided on at least one side of the bending axis on the first film layer.

According to the above technical solution, when the substrate undergoes bending, two opposite sides of the bending axis on the first film layer bend and deform around the bending axis. The through-hole provided on at least one side of the bending axis on the first film layer can restrict a radius of curvature of the first film layer on such side during bending, thereby reducing the risk of damage due to excessive bending.

In some embodiments, the through-holes are sequentially arranged on the first film layer in a direction perpendicular to the bending axis.

According to the above technical solution, when the substrate undergoes bending, the first film layer bends and deforms around the bending axis. The through-holes are sequentially arranged in a direction perpendicular to the bending axis, that is, the through-holes are arranged along a bending direction of the first film layer. The through-hole can reduce stress experienced by the first film layer around the bending axis, thereby improving bending resistance.

In some embodiments, adjacent through-holes have a spacing therebetween, and the spacing increases in a direction away from the bending axis.

According to the above technical solution, when the substrate undergoes bending, the first film layer bends and deforms around the bending axis. It can be understood that a portion of the first film layer farther from the bending axis exhibits a smaller degree of bending. Therefore, configuring the spacing between adjacent through-holes to increase in a direction away from the bending axis, that is, making the through-holes become sparser in a direction away from the bending axis, is for adapting to variations in the degrees of bending deformation of the first film layer. In this case, the through-holes can be reduced, simplifying hole-forming on the first film layer.

In some embodiments, the through-holes are provided on two opposite sides of the bending axis on the first film layer, and at least two of the through-holes are symmetrically distributed with respect to the bending axis.

According to the above technical solution, when the substrate undergoes bending, the portions of the first film layer on two opposite sides of the bending axis bend and deform around the bending axis. The symmetrically distributed through-holes can simultaneously improve bending resistance of the first film layer on two opposite sides of the bending axis, enhancing symmetry of the first film layer on two opposite sides of the bending axis.

In some embodiments, the through-hole is a strip through-hole, and a length direction of the strip through-hole is parallel to an extension direction of the bending axis.

According to the above technical solution, the through-hole is a strip through-hole with a length direction of the strip through-hole parallel to the extension direction of the bending axis, that is, the through-holes are distributed parallel to the bending axis. When the substrate undergoes bending, the first film layer bends and deforms around the bending axis, and the strip through-hole restricts the radius of curvature of a portion of the first film layer between adjacent strip through-holes during bending, thereby reducing the risk of damage to the first film layer due to bending.

In some embodiments, the substrate further includes a second film layer, and the second film layer is attached to the first film layer.

According to the above technical solution, the first film layer is attached to the second film layer. The second film layer improves bending resistance with a through-hole provided thereon. The first film layer serves as a base structure to support assembly of components of the solar cell, thereby reducing impact on the assembly of other components during formation of the through-hole.

In some embodiments, the first film layer is a plastic film layer; and/or the second film layer is a plastic film layer.

According to the above technical solution, selecting a plastic film layer as the first film layer, and/or selecting a plastic film layer as the second layer, enables the first film layer and the second film layer to exhibit strong support and optical transparency.

In some embodiments, the substrate further includes a central layer, the central layer is elastic, the central layer includes a first end surface and an opposite second end surface, the first film layer is attached to the first end surface, and the second film layer is attached to the second end surface.

According to the above technical solution, when the substrate undergoes bending, the first film layer, the central layer, and the second layer bend synchronously. The first film layer and the second film layer are subjected to tensile stress and compressive stress respectively. The elastic central layer counteracts the tensile stress and compressive stress experienced by the first film layer and the second film layer, thereby reducing the stress on the first film layer and the second film layer, and improving bending resistance of the substrate.

In some embodiments, the central layer is provided with a penetrating hole, and the penetrating hole is in communication with the through-hole.

According to the above technical solution, the penetrating hole is provided on the central layer to reduce an area of the central layer exposed to the first film layer through the through-hole, thereby reducing the impact on the optical transparency of the central layer caused by dust passing through the through-hole and accumulating on the central layer.

In some embodiments, the penetrating hole is aligned with the through-hole.

According to the above technical solution, the penetrating hole aligned with the through-hole is provided on the central layer to prevent the central layer from being exposed to the first film layer through the through-hole, thereby reducing the impact on the optical transparency of the central layer caused by dust passing through the through-hole and accumulating on the central layer.

In some embodiments, the central layer is a clear adhesive layer.

According to the above technical solution, the clear adhesive layer is a polymeric viscoelastic layer. When bent, the clear adhesive layer undergoes significant deformation to counteract the tensile stress and compressive stress experienced by the first film layer and the second film layer, and when unbent, the deformation of the clear adhesive layer is recoverable.

According to a second aspect, an embodiment of this application provides a solar cell, where the solar cell includes the substrate as described above.

Beneficial effects of this embodiment of this application are as follows. The solar cell provided by this embodiment of this application includes the substrate described above. With the substrate exhibiting good bending resistance, the substrate of the solar cell can withstand a greater number of bends, thereby enhancing stability of the solar cell.

According to a third aspect, an embodiment of this application further provides a photovoltaic system, where the photovoltaic system includes the solar cell as described above.

Beneficial effects of this embodiment of this application are as follows. The photovoltaic system provided by this embodiment of this application includes the solar cell described above. With the solar cell exhibiting good stability, the photovoltaic system also exhibits good stability.

According to a fourth aspect, an embodiment of this application provides an electric device, where the electric device includes the solar cell as described above.

Beneficial effects of this embodiment of this application are as follows. The electric device provided by this embodiment of this application includes the solar cell described above. With the solar cell exhibiting good stability, the electric device also exhibits good stability.

### BRIEF DESCRIPTION OF DRAWINGS

To more clearly illustrate technical solutions in embodiments of this application, the drawings for describing the embodiments or related art are briefly introduced below. It is clear that the drawings described below represent only some embodiments of this application. Persons of ordinary skill in the art may obtain other drawings based on these drawings without creative efforts.
FIG. 1 is a schematic structural diagram of a solar cell assembly in a photovoltaic system according to an embodiment of this application;
FIG. 2 is a schematic diagram of a layered structure of a perovskite solar cell according to an embodiment of this application;
FIG. 3 is a schematic structural diagram of a 1st first film layer according to an embodiment of this application;
FIG. 4 is a schematic structural diagram of a 2nd first film layer according to an embodiment of this application;
FIG. 5 is a schematic structural diagram of a 3rd first film layer according to an embodiment of this application;
FIG. 6 is a schematic structural diagram of a 4th first film layer according to an embodiment of this application; and
FIG. 7 is a schematic diagram of a layered structure of a substrate according to an embodiment of this application.

### Reference signs:

1000. solar cell assembly;
1100. solar cell; 1110. substrate; 1111. transparent electrode layer; 1120. first charge transport layer; 1130. perovskite light-absorbing layer; 1140. second charge transport layer; 1150. metal electrode layer;
100. first film layer; 101. first side portion; 102. second side portion; 110. through-hole; 111. first hole portion; 112. second hole portion;
200. central layer;
300. second film layer;
a. bending axis; and b. spacing.

### DESCRIPTION OF EMBODIMENTS

Embodiments of this application are described in detail below. Examples of the embodiments are shown in the accompanying drawings, where identical or similar reference signs denote identical or similar elements or elements having identical or similar functions throughout. The embodiments described below with reference to the accompanying drawings are illustrative and intended to explain this application, and should not be construed as limitations on this application.

Unless otherwise defined, all technical and scientific terms used herein have the same meanings as commonly understood by persons skilled in the technical field of this application. The terms used herein are solely for describing specific embodiments and are not intended to limit this application. The terms "comprise", "include", and any variants thereof in the descriptions of the specification, claims, and accompanying drawings of this application are intended to cover a non-exclusive inclusion.

In the description of the embodiments of this application, orientations or positional relationships indicated by the terms "length", "width", "thickness", "inside", "outside", "up", "down", "front", "left", "right", and similar terms are based on orientations or positional relationships shown in the accompanying drawings. These terms are used merely to simplify the description of this application for ease of description, and do not indicate or imply that an apparatus or a component must have a specific orientation or be constructed and operated in a specific orientation. Therefore, these terms should not be construed as limitations on this application.

The terms "first", "second", and the like are used merely for distinguishing descriptions and should not be understood as indication or implication of relative importance or implicit indication of the number of technical features. For example, a first guide member and a second guide member are merely used to distinguish different guide members and do not limit their order. The first guide member may also be referred to as a second guide member, and the second guide member may also be referred to as a first guide member, without departing from the scope of the various described embodiments. The terms "first", "second", and the like do not necessarily mean that the indicated features must be different.

In the description of the embodiments of this application, unless otherwise expressly specified and defined, the terms "connection", "join", and the like should be understood in a broad sense, and for example, may refer to a fixed connection, a detachable connection, or an integral connection; a mechanical connection or an electrical connection; a direct connection, an indirect connection via an intermediate medium, an internal communication between two elements, or an interaction between two elements. Persons of ordinary skill in the art can understand the specific meanings of these terms in this application based on specific contexts. The term "a plurality of" means at least two, that is, two or more.

The term "and/or" in this application is merely an associative relationship describing associated objects, indicating that three relationships may exist. For example, A and/or B may indicate three cases: presence of A alone, presence of both A and B, and presence of B alone. Additionally, the character "/" in this application generally indicates an "or" relationship between contextually associated objects.

It should be noted that terms such as "in some embodiments", "example", "for example", and the like used in this application are intended to serve as examples, illustrations, or explanations. Any embodiment or design described as "in some embodiments", "example", "for example", or the like in this application should not be construed as being more preferred or advantageous than other embodiments or designs. Specifically, the use of terms such as "in some embodiments", "example", and "for example" is intended to present related concepts in a concrete manner, indicating that specific features, structures, or characteristics described with reference to the embodiments may be included in at least one embodiment of this application. The appearance of such terms in various places in the specification does not necessarily refer to the same embodiment, nor is it an independent or alternative embodiment mutually exclusive with other embodiments. It is explicitly or implicitly understood by persons skilled in the art that the embodiments described herein may be combined with other embodiments.

To make the objectives, technical solutions, and advantages of this application more comprehensible, this application is described in detail below with reference to the embodiments and accompanying drawings.

A solar cell is a photoelectric semiconductor sheet that directly generates electricity from sunlight, also known as a "solar chip" or "photovoltaic cell". When exposed to light with sufficient illuminance, the solar cell instantly outputs voltage and generates current in an electric circuit. With the rapid development of the new energy sector, solar cells have been widely applied in fields such as military, aerospace, industry, commerce, agriculture, and communications. Perovskite solar cells, with advantages such as high photoelectric conversion efficiency, simple manufacturing processes, and low production and material costs, have gradually become a focal point of research for next-generation solar cells.

In related art, a solar cell includes a cell body and a substrate, where the substrate is flexible, enabling the substrate to bend and form a curved surface to adapt to environments with curved surfaces, thereby expanding the application of the solar cells. However, during repeated bending of the substrate of the solar cell, the substrate develops noticeable bending marks, and in severe cases, may suffer damage or fracture, leading to damage to the solar cell.

To address the above issue, an embodiment of this application provides a substrate, where the substrate includes a first film layer, and a through-hole is formed on the first film layer. When the substrate undergoes bending, the first film layer bends accordingly. Due to the through-hole formed on the first film layer, a portion of the first film layer surrounding the through-hole forms a discontinuous layer during bending. Compared with a continuous layer, bending of a discontinuous layer is easier, that is, the discontinuous layer experiences less stress during bending. Thus, the first film layer with the through-hole withstands a greater number of bends without developing bending marks or suffering damage, thereby improving bending resistance of the first film layer, and further improving bending resistance of the substrate. This effectively reduces the risk that the substrate develops bending marks, fractures, or breaks during repeated bending.

The substrate disclosed in embodiments of this application may be used, but is not limited to, in electric devices such as vehicles, ships, or aircraft, and may also be used in photovoltaic systems. A power system of an electric device may be formed by the substrate, solar cell, and other components disclosed in this application. This improves bending resistance of the solar cell substrate, thereby prolonging a service life of the solar cell.

An embodiment of this application provides an electric device using a solar cell as a power source. The electric device may be used in fields such as communications, transportation, industry, agriculture, and lighting. The electric device may be, but is not limited to, satellites, communications equipment, traffic signal lights, lighthouses, wireless telephone booths, monitoring equipment, power systems, camping lights, electric vehicles, and chargers for electronic devices.

An embodiment of this application further provides a photovoltaic system, where the photovoltaic system includes a solar cell. The photovoltaic system may be an off-grid photovoltaic power generation system or a grid-connected photovoltaic power generation system. An off-grid photovoltaic power generation system includes a photovoltaic array, a battery pack, a charge controller, a power electronic converter (inverter), and a load. An operating principle is that solar radiation energy is first converted into electrical energy by the photovoltaic array, then transformed by the power electronic converter to supply the load, while excess electrical energy is stored in an energy storage apparatus in a form of chemical energy after passing through the charge controller. When sunlight is insufficient, the energy stored in the battery can be converted into 220 V and 50 Hz alternating-current power through the power electronic inverter, filter, and power frequency transformer for use by an alternating-current load. A grid-connected photovoltaic power generation system includes a photovoltaic array, a high-frequency DC/DC boost circuit, a power electronic converter (inverter), and system monitoring. An operating principle is that solar radiation energy is converted by the photovoltaic array, transformed into high-voltage direct current through high-frequency direct current conversion, and then inverted by the power electronic inverter to output, to the power grid, sinusoidal alternating current synchronized with a grid voltage and frequency. The two types of photovoltaic power generation systems have distinct characteristics and may be selected based on specific application scenarios.

For ease of description, the following embodiments are described using an example in which a solar cell of an embodiment of this application is used in a photovoltaic system.

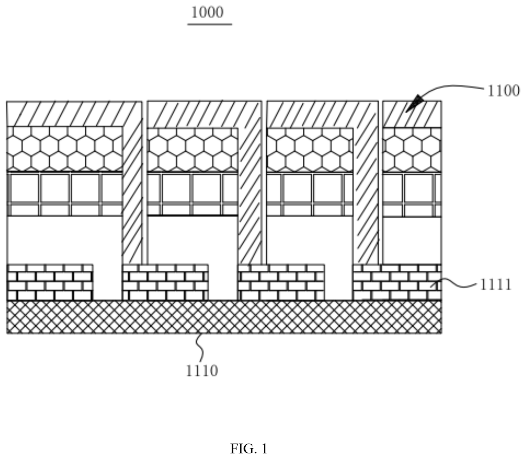

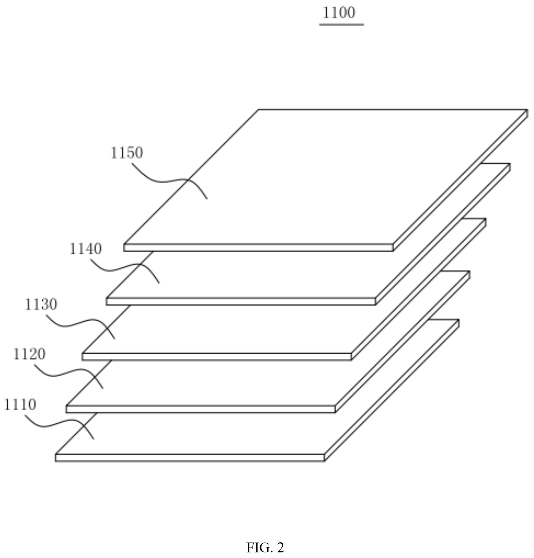

Refer to FIG. 1 and FIG. 2. FIG. 1 is a schematic structural diagram of a solar cell assembly 1000 in a photovoltaic system provided by some embodiments of this application. The solar cell assembly 1000 includes a plurality of solar cells 1100. As shown in FIG. 2, for example, the solar cell 1100 is a perovskite solar cell, where the perovskite solar cell includes, in a thickness direction, a substrate 1110, a first charge transport layer 1120, a perovskite light-absorbing layer 1130, a second charge transport layer 1140, and a metal electrode layer 1150. The substrate 1110 serves as a carrier for the entire perovskite solar cell, providing an environment for assembling other layer structures such as a transparent electrode layer 1111. The substrate 1110 includes a base body and the transparent electrode layer 1111, where the transparent electrode layer 1111 is attached to the base body. In embodiments of this application, a first film layer 100 of the substrate 1110 is a part of the base body. Additionally, the substrate 1110 is flexible, enabling the substrate 1110 to bend and form different curved surfaces to adapt to various installation environments.

The substrate 1110 provided by an embodiment of this application is described below.

Refer to FIG. 2 to FIG. 4. An embodiment of this application provides a substrate 1110, where the substrate 1110 includes a first film layer 100, and at least one through-hole 110 is formed on the first film layer 100.

It can be understood that the substrate 1110 is a base portion of the solar cell 1100, and the substrate 1110 serves as a carrier for fabricating other components of the solar cell 1100. The substrate 1110 includes the first film layer 100, where a material of the first film layer 100 may include, but is not limited to, flexible materials such as glass, tempered glass, quartz, carbon, silicon, or plastic. Specifically, the plastic material may include polyethylene terephthalate, polyethylene naphthalate, or polyimide.

It should be understood that when the substrate 1110 undergoes bending, the first film layer 100 bends simultaneously, and the first film layer 100 undergoes elastic deformation as a whole. For example, the first film layer 100 may bend to form a structure with a C-shaped cross-section. Specifically, a direction of bending is not limited in this embodiment and may be selected based on actual conditions.

The through-hole 110 is formed on the first film layer 100 and is a hole structure penetrating the first film layer 100 in a thickness direction of the first film layer 100. The through-hole 110 reduces stress experienced by the first film layer 100 during bending, thereby improving bending performance of the first film layer 100. Additionally, forming the through-hole 110 on the first film layer 100 enhances a transmittance of the first film layer 100 to some extent.

It can be understood that providing the through-hole 110 on the first film layer 100 allows formation of a discontinuous layer structure at the through-hole 110 in the interrupted first film layer 100. When the first film layer 100 bends, the absence of the first film layer 100 at the through-hole 110 makes bending of the discontinuous first film layer 100 easier. That is, the first film layer 100 with the through-hole 110 experiences less stress, enabling the first film layer 100 to withstand a greater number of bends without developing bending marks or suffering damage, thereby improving bending resistance of the first film layer 100.

Specifically, the through-hole 110 may include, but is not limited to, a structure such as a circular hole, a rectangular hole, a strip hole, a slotted hole, or a triangular hole. A quantity of through-holes 110 is not limited. One, two, or more through-holes 110 may be provided. A type and quantity of the through-hole 110 may be customized based on actual needs.

Additionally, the through-hole 110 may be formed at any location on the first film layer 100. For example, the through-hole 110 may be formed at a center of the first film layer 100, or the through-hole 110 may be formed at an outer edge of the first film layer 100, or through-holes 110 may be formed at both the outer edge and the center of the first film layer 100.

In some specific implementations, when a plurality of through-holes 110 are provided, the through-holes 110 may be arranged in an array on the first film layer 100, or the through-holes 110 may be arranged irregularly on the first film layer 100.

In the substrate 1110 provided by embodiments of this application, when the substrate 1110 undergoes bending, the first film layer 100 bends and deforms accordingly. Since the through-hole 110 is provided on the first film layer 100, the through-hole 110 can reduce stress due to bending experienced by the first film layer 100 surrounding the through-hole, thereby improving bending resistance of the first film layer 100, and further improving bending resistance of the substrate 1110. This reduces the risk that the substrate 1110 develops bending marks, fractures, or breaks during repeated bending, thereby prolonging a service life of the substrate 1110.

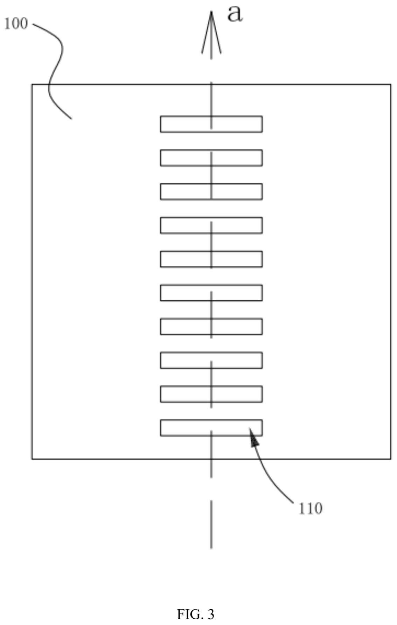

Refer to FIG. 3. In some embodiments, the first film layer 100 includes a bending axis a, where the bending axis a passes through at least some of through-holes 110.

The bending axis a refers to an axis around which the first film layer 100 undergoes bending deformation. It should be understood that since the first film layer 100 bends and deforms around the bending axis a, the first film layer 100 exhibits a greater degree of bending deformation at the bending axis a, while a portion of the first film layer 100 farther from the bending axis a exhibits a smaller degree of bending deformation.

One or more through-holes 110 may be provided. For example, when one through-hole 110 is provided, the bending axis a passes through the through-hole 110, that is, the through-hole 110 is formed in a region of the first film layer 100 at the bending axis a. When the first film layer 100 undergoes bending, the first film layer exhibits a greater degree of bending deformation at the bending axis a, and the through-hole 110 reduces stress experienced by the first film layer 100 due to bending, thereby improving bending resistance of the first film layer 100, and further improving bending resistance of the substrate 1110.

When a plurality of through-holes 110 are provided, the bending axis a may sequentially pass through each through-hole 110, and the plurality of through-holes 110 can reduce stress experienced by the first film layer 100 due to bending in a region undergoing a greater degree of bending deformation. Alternatively, when a plurality of through-holes 110 are provided, the bending axis a may pass through some of the through-holes 110, while other through-holes 110 are formed in a portion of the first film layer 100 away from the bending axis a. The through-holes 110 through which the bending axis a passes can reduce stress experienced by the first film layer 100 in the region undergoing a greater degree of bending deformation due to bending, while other through-holes 110 can reduce stress experienced by the first film layer 100 in other regions due to bending, enabling reduction in stress experienced by the first film layer 100 due to bending at multiple locations.

With such configuration, when the substrate 1110 undergoes bending, the first film layer 100 bends and deforms around the bending axis a. It can be understood that the first film layer 100 exhibits the greatest degree of bending deformation at the bending axis a. The bending axis a passes through at least some of the through-holes 110, thereby enabling the through-hole 110 to more effectively reduce stress experienced by the first film layer 100 in a bent state and improve bending resistance.

Refer to FIG. 2 and FIG. 3. In some embodiments, the bending axis a passes through each through-hole 110.

It can be understood that one or more through-holes 110 may be provided.

When one through-hole 110 is provided, the bending axis a passes through the through-hole 110, that is, the through-hole 110 is at the bending axis a on the first film layer 100. For example, the through-hole 110 may be in any hole shape such as a circular hole, a triangular hole, or a rectangular hole, and may be formed at any position along an extension direction of the bending axis a of the first film layer 100, as long as the bending axis a passes through the through-hole 110. Alternatively, the through-hole 110 may be a strip hole, with a length direction of the strip hole configured along the direction of the bending axis a, enabling the through-hole 110 to create a discontinuous layer in the first film layer 100, making bending of the first film layer 100 easier due to the through-hole 110.

When a plurality of through-holes 110 are provided, the plurality of through-holes 110 are arranged along an extension direction of the bending axis a, and spacings between the through-holes 110 may be the same or different, or the spacings between the through-holes 110 may increase or decrease in a certain direction, or first increase and then decrease, or first decrease and then increase. For example, the through-hole 110 may be in, but is not limited to, any hole shape such as a circular hole, a triangular hole, or a rectangular hole.

With such configuration, the through-holes 110 are sequentially arranged along the extension direction of the bending axis a. When the substrate 1110 undergoes bending, the first film layer 100 bends and deforms around the bending axis a. At this time, the through-holes 110 can more effectively reduce stress experienced by the first film layer 100 and improve bending resistance.

Refer to FIG. 3. In some embodiments, each of the at least one through-hole 110 is symmetrically arranged with respect to the bending axis a.

It can be understood that one or more through-holes 110 may be provided.

When one through-holes 110 is provided, the bending axis a passes through a geometric center of the through-hole 110, and the through-hole 110 is symmetric with respect to the bending axis a. Specifically, the through-hole 110 may be, but is not limited to, a symmetric hole such as a circular hole, a slotted hole, an equilateral triangular hole, or a rectangular hole.

When a plurality of through-holes 110 are provided, the plurality of through-holes 110 may be sequentially arranged along an extension direction of the bending axis a. The bending axis a may pass through geometric centers of some of the through-holes 110, or the bending axis a may respectively pass through a geometric center of each through-hole 110. Specifically, the through-hole 110 may include, but is not limited to, a symmetric hole such as a circular hole, a slotted hole, an equilateral triangular hole, or a rectangular hole. Hole shapes of the plurality of through-holes 110 may be the same or different.

With such configuration, since at least one through-hole 110 is symmetric with respect to the bending axis a, when the first film layer 100 bends around the bending axis a, the symmetric through-hole 110 can synchronously reduce stress experienced by portions of the first film layer 100 on both sides of the bending axis a due to bending. When the bending axis a coincides with a central axis of the first film layer 100, the portions of the first film layer 100 on both sides of the bending axis a maintain symmetric.

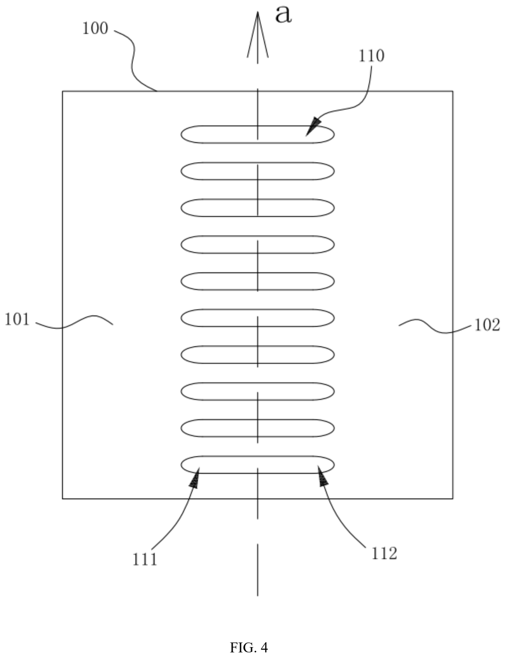

Refer to FIG. 4. In some embodiments, a width of the through-hole 110 tends to decrease in a direction away from the bending axis a.

The width of the through-hole 110 tends to decrease in the direction away from the bending axis a, meaning that in a direction away from the bending axis a, the width of the through-hole 110 may gradually decrease, or first remain constant and then gradually decrease, or exhibit a cyclic change of remaining constant and then decreasing, or exhibit a cyclic change of decreasing and then remaining constant. For ease of description, two portions of the first film layer 100 are described independently, with the bending axis a as a dividing line. A portion of the first film layer 100 on one side of the bending axis a is described as a first side portion 101, while another portion of the first film layer on another side of the bending axis a is described as a second side portion 102, to describe the positional distribution of the through-hole on the first film layer 100.

Since the bending axis a passes through the through-hole 110, the portion of the through-hole 110 is provided in the first side portion 101 of the first film layer 100 (for ease of description, the portion of the through-hole 110 in the first side portion 101 is referred to as a first hole portion 111). Specifically, the first hole portion 111 may be, but is not limited to, a closing structure such as a semicircular hole portion (half circle or half ellipse), a triangular hole portion, or a trapezoidal hole portion, with a closing direction away from the bending axis a. For example, the closing direction may be perpendicular to the bending axis a.

Similarly, since the bending axis a passes through the through-hole 110, the portion of the through-hole 110 is provided in the second side portion 102 of the first film layer 100 (for ease of description, the portion of the through-hole 110 in the second side portion 102 is referred to as a second hole portion 112). Specifically, the second hole portion 112 may be, but is not limited to, a closing structure such as a semicircular hole portion (half circle or half ellipse), a triangular hole portion, or a trapezoidal hole portion, with a closing direction away from the bending axis a. For example, the closing direction may be perpendicular to the bending axis a.

For example, in some specific implementations, the through-hole 110 includes the first hole portion 111 and the second hole portion 112, where the first hole portion 111 and the second hole portion 112 are in communication and combine to form a complete through-hole 110. When both the first hole portion 111 and the second hole portion 112 are semicircular hole portions, the through-hole 110 may be a circular hole, an elliptical hole, or a slotted hole. Alternatively, when both the first hole portion 111 and the second hole portion 112 are triangular hole portions, the through-hole 110 may be a square hole or a rhombic hole. Alternatively, when both the first hole portion 111 and the second hole portion 112 are trapezoidal hole portions, the through-hole 110 may be a hexagonal hole. Alternatively, in other specific implementations, hole shapes of the first hole portion 111 and the second hole portion 112 may be different.

With such configuration, when the substrate 1110 undergoes bending, the first side portion 101 and the second side portion 102 of the first film layer 100 bend and deform around the bending axis a. It can be understood that a portion of the first film layer 100 farther from the bending axis a exhibits a smaller degree of bending. Therefore, the width of the first hole portion 111 is configured to decrease in the direction away from the bending axis a to adapt to variations in the degrees of bending of the first film layer 100. Similarly, the width of the second hole portion 112 is also configured to decrease in the direction away from the bending axis a to adapt to variations in the degrees of bending of the first film layer 100.

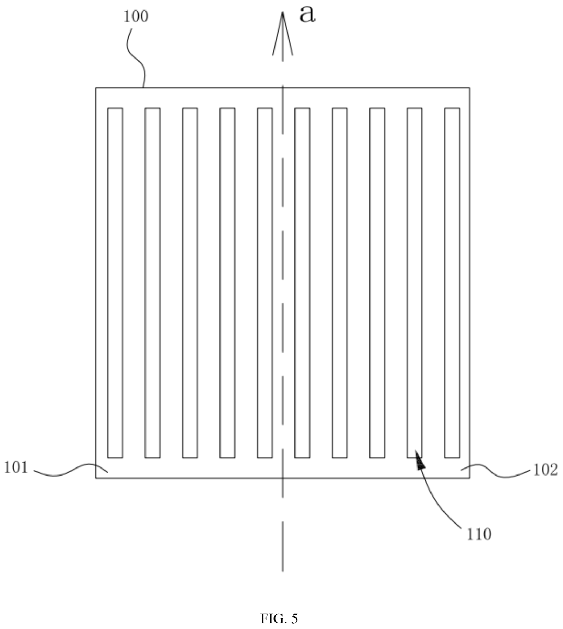

Refer to FIG. 5. In some embodiments, the first film layer 100 has a bending axis a, and the through-hole 110 is provided on at least one side of the bending axis a on first film layer 100.

It can be understood that one or more through-holes 110 may be provided.

When one through-hole 110 is provided, the through-hole 110 may be provided on the first side portion 101 of the first film layer 100 on one side of the bending axis a or on the second side portion 102 on the other side of the bending axis a. When the first side portion 101 or the second side portion 102 undergoes bending, the through-hole 110 can reduce stress experienced by the first side portion 101 or the second side portion 102 during bending.

When a plurality of through-holes 110 are provided, the plurality of through-holes 110 may all be provided in the first side portion 101 of the first film layer 100 on one side of the bending axis a or in the second side portion 102 on the other side of the bending axis a. When the first film layer 100 undergoes bending, these through-holes 110 can reduce stress experienced by the first side portion 101 or the second side portion 102 during bending. Alternatively, some of the plurality of through-holes 110 may be provided in the first side portion 101, and other through-holes 110 may be provided in the second side portion 102, that is, the through-holes 110 are provided in both the first side portion 101 and the second side portion 102. When the first film layer 100 undergoes bending, these through-holes 110 can respectively reduce stress experienced by the first side portion 101 and the second side portion 102 during bending.

Specifically, when a plurality of through-holes 110 are provided, the through-holes 110 may be arranged in any direction. For example, the through-holes 110 may be spaced apart along a direction parallel to the extension direction of the bending axis a, or the through-holes 110 may be spaced apart along a direction at any angle with the bending axis a. For example, the angle between the arrangement direction of the through-holes 110 and the bending axis a may be, but not limited to, 0° to 180°. Specifically, the angle may be, but not limited to, 10°, 30°, 45°, 60°, 90°, 120°, 135°, 150°, or the like. Additionally, spacings between the through-holes 110 may all be the same or partially the same, or the spacings between the through-holes 110 may increase or decrease in a specific direction.

The above through-hole 110 may be in, but is not limited to, any hole shape such as a circular hole, a rectangular hole, a strip hole, or a wavy hole.

With such configuration, when the first film layer 100 undergoes bending, the first side portion 101 and the second side portion 102 of the first film layer 100 bend and deform around the bending axis a. The through-hole 110 provided in at least one of the first side portion 101 and the second side portion 102 can reduce stress during bending, or a plurality of through-holes 110 can restrict a radius of curvature of a portion of the first film layer 100 between adjacent through-holes 110 during bending, thereby reducing the risk of damage due to excessive bending.

Refer to FIG. 5. In some embodiments, the through-holes 110 are sequentially arranged on the first film layer 100 in a direction perpendicular to the bending axis a.

It can be understood that a plurality of through-holes 110 are provided, and the through-holes 110 are arranged in the direction perpendicular to the bending axis a. The hole shapes of the plurality of through-holes 110 may be the same, such as all are circular holes, rectangular holes, strip holes, or wavy holes, or the hole shapes of the plurality of through-holes 110 may be partially the same or all different. The hole shape of the through-hole 110 may be customized based on actual needs.

For example, in some specific implementations, a plurality of through-holes 110 may be provided, the hole shape of the through-hole 110 may be rectangular, and a length direction of the rectangular through-hole 110 is parallel to a direction of the bending axis a. The plurality of rectangular through-holes 110 are arranged on the first film layer 100 in a direction perpendicular to the bending axis a. It can be understood that the first film layer 100 undergoes bending deformation around the bending axis a, that is, the direction perpendicular to the bending axis a is a bending direction of the first film layer 100, meaning the plurality of rectangular through-holes 110 are arranged along the bending direction of the first film layer 100. When the first film layer 100 bends and deforms around the bending axis a, the first film layer 100 forms a discontinuous layer due to each of the rectangular through-holes 110, reducing stress experienced by the first film layer 100 during bending. Additionally, a radius of curvature of a portion of the first film layer 100 between two adjacent rectangular through-holes 110 is restricted during bending, thereby reducing the risk of damage due to excessive bending.

Specifically, an even number of through-holes 110 may be provided, and any through-hole 110 on one side of the bending axis a has a corresponding symmetric through-hole 110 on the other side of the bending axis a. Additionally, spacings between the through-holes 110 may all be the same, or spacings between the through-holes 110 may increase or decrease in a direction perpendicular to and away from the bending axis a.

With such configuration, when the substrate 1110 undergoes bending, the first film layer 100 bends and deforms around the bending axis a. The through-holes 110 are sequentially arranged in a direction perpendicular to the bending axis a, that is, the through-holes 110 are arranged along a bending direction of the first film layer 100. The through-holes 110 can reduce stress experienced by the first film layer 100 around the bending axis a, thereby improving bending resistance.

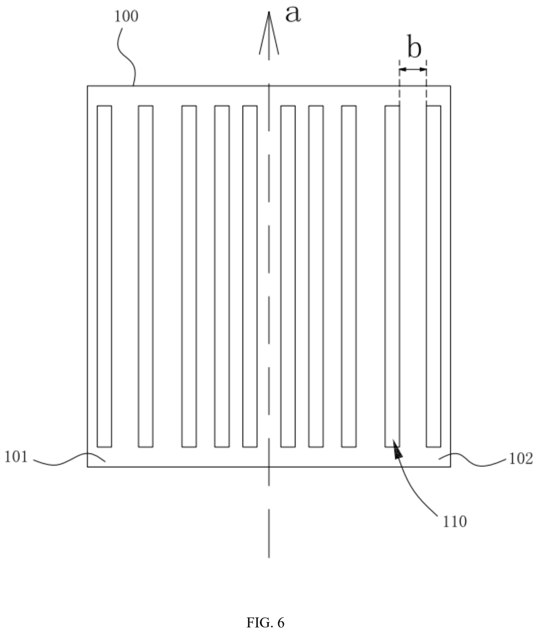

Refer to FIG. 6. In some embodiments, adjacent through-holes 110 have a spacing b therebetween, and the spacing b increases in a direction away from the bending axis a.

It should be understood that at least three through-holes 110 are provided, resulting in at least two spacings b between adjacent through-holes 110, and then the at least two spacings b exhibit an increasing trend.

The spacing b refers to a distance between center points of adjacent through-holes 110. The increasing trend of the spacings b means that in a direction away from the bending axis a, spacings b between adjacent through-holes 110 may always increase, or the spacings b between adjacent through-holes 110 may remain constant and then increase, or the spacings b between adjacent through-holes 110 may first increase and then remain constant. The specific distribution of the through-holes 110 may be customized based on actual needs as long as the spacings b between adjacent through-holes 110 exhibit an increasing trend in a direction away from the bending axis a, or the distribution of the through-holes 110 becomes sparser in a direction away from the bending axis a.

It can be understood that the first film layer 100 undergoes bending deformation around the bending axis a, a portion of the first film layer 100 closer to the bending axis a exhibits a greater degree of bending deformation, and a portion of the first film layer 100 away from the bending axis a exhibits a smaller degree of bending deformation. Therefore, configuring the spacing b to increase in a direction away from the bending axis a, that is, making the through-holes 110 become denser on the first film layer 100 at the bending axis a and sparser on the first film layer 100 away from the bending axis a, enables the distribution of the through-holes 110 to adapt to variations in the degrees of bending deformation of the first film layer 100.

With such configuration, a portion of the first film layer 100 farther from the bending axis a exhibits a smaller degree of bending. Therefore, configuring the spacing b between adjacent through-holes 110 to increase in a direction away from the bending axis a, that is, making the through-holes 110 become sparser in a direction away from the bending axis a, is for adapting to variations in the degrees of bending deformation of the first film layer 100. In this case, the through-holes 110 can be reduced, simplifying hole-forming on the first film layer 100.

Refer to FIG. 5 or FIG. 6. In some embodiments, the through-holes 110 are provided on two opposite sides of the bending axis a on the first film layer 100, and at least two through-holes 110 are symmetrically distributed with respect to the bending axis a.

It can be understood that the through-holes 110 may be in an even number greater than or equal to two, and the first side portion 101 of the first film layer 100 on one side of the bending axis a and the second side portion 102 of the first film layer 100 on the other side of the bending axis a may be symmetrically arranged.

For example, in some specific implementations, a plurality of through-holes 110 are provided on the first film layer 100. The through-hole 110 may be a strip hole with a length direction parallel to the extension direction of the bending axis a. The through-holes 110 are sequentially arranged in a direction perpendicular to the bending axis a. Any through-hole 110 on the first side portion 101 has another through-hole 110 on the second side portion 102 symmetric therewith with respect to the bending axis a.

In other specific implementations, a plurality of through-holes 110 are provided on the first film layer 100. The through-hole 110 may be in any hole shape such as a circular hole or a rectangular hole, and the through-holes 110 are arranged in an array on the first film layer 100, for example, arranged in four rows and four columns, five rows and six columns, or the like. The specific array form of the through-holes 110 may be customized based on actual needs. The examples provided herein are merely for illustration and do not limit the form of the array.

With such configuration, when the substrate 1110 undergoes bending, the first side portion 101 and the second side portion 102 of the first film layer 100 bend and deform around the bending axis a. The symmetrically distributed through-holes 110 can simultaneously improve bending resistance of the first side portion 101 and the second side portion 102, enhancing symmetry of the first side portion 101 and the second side portion 102.

Refer to FIG. 5 or FIG. 6. In some embodiments, the through-hole 110 is a strip through-hole, and a length direction of the strip through-hole is parallel to the extension direction of the bending axis a.

It can be understood that a specific form of the strip through-hole may be as follows. The through-hole 110 is a rectangular hole, and a length of the rectangular hole is significantly greater than a width thereof. Alternatively, the specific form of the strip through-hole, namely, the through-hole 110, may be a wavy hole. Alternatively, the specific form of the strip through-hole 110 is as follows. The through-hole 110 may be an elliptical hole or the like.

For example, in some specific implementations, a plurality of strip through-holes are provided, and the strip through-hole is rectangular, with a length of the rectangle significantly greater than a width thereof. The through-holes 110 are arranged in a direction perpendicular to the bending axis a, and any strip through-hole has another strip through-hole symmetric therewith with respect to the bending axis a. When the first film layer 100 undergoes bending, the first side portion 101 and the second side portion 102 of the first film layer 100 bend around the bending axis a. The first side portion 101 and the second side portion 102 experience the same stress reduction, thereby enhancing consistency of bending of the first side portion 101 and the second side portion 102.

With such configuration in which the through-holes 110 are strip through-holes with a length direction of the strip through-hole parallel to the extension direction of the bending axis a, that is, the strip through-holes are distributed parallel to the bending axis a, when the substrate 1110 undergoes bending, the first film layer 100 bends and deforms around the bending axis a, and the strip through-holes enable formation of a discontinuous layer in the interrupted first film layer 100, restricting the radius of curvature of a portion of the first film layer 100 between adjacent through-holes 110 during bending, thereby reducing the risk of damage to the first film layer 100 due to bending.

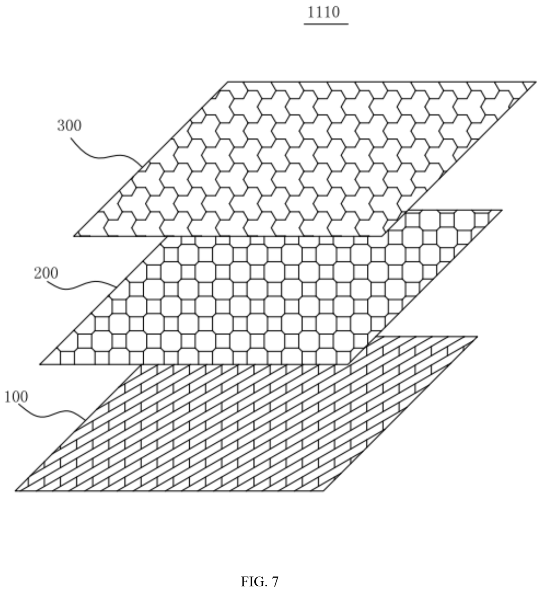

Refer to FIG. 7. In some embodiments, the substrate 1110 further includes a second film layer 300, and the second film layer 300 is attached to the first film layer 100.

The second film layer 300 may serve as an inner layer, that is, the second film layer 300 may be specifically configured to attach to the transparent electrode layer 1111 of the solar cell 1100. In this case, the first film layer 100 may serve as an outer layer, and the first film layer 100 may be disposed on a side of the second film layer 300 away from the transparent electrode layer 1111, and configured to provide support and connect to an external structure.

Specifically, a material of the second film layer 300 may include, but is not limited to, organic flexible materials such as glass, tempered glass, quartz, carbon, silicon, or plastic. Specifically, the plastic material may be polyethylene terephthalate, polyethylene naphthalate, or polyimide. The material of the second film layer 300 may be the same as or different from the material of the first film layer 100, and may be selected based on actual needs.

With such configuration, the first film layer 100 is attached to the second film layer 300. The second film layer 300 improves bending resistance with a through-hole 110 provided thereon. The first film layer 100 serves as a base structure to support assembly of components of the solar cell, thereby reducing the impact on the assembly of other components during formation of the through-hole 110.

Refer to FIG. 2 and FIG. 7. In some embodiments, the substrate 1110 further includes a central layer 200, the central layer 200 is elastic, and the central layer 200 includes a first end surface and an opposite second end surface. The first film layer 100 is attached to the first end surface, and the second film layer 300 is attached to the second end surface.

The central layer 200 may be, but is not limited to, a transparent rubber layer, a transparent silicone layer, or an optically clear adhesive layer as long as the central layer 200 satisfies requirements for optical transparency and elasticity.

The central layer 200 is disposed between the first film layer 100 and the second film layer 300, and the central layer 200 serves to connect the first film layer 100 and the second film layer 300. For example, the first film layer 100 may be attached to the first end surface of the central layer 200, and the second film layer 300 may be attached to the second end surface of the central layer 200. Alternatively, protruding structures may be provided on the first end surface and the second end surface of the central layer 200, with corresponding groove structures provided on the first film layer 100 and the second film layer 300. The protruding structures engage with the groove structures to fix the first film layer 100 and the second film layer 300 to the first end surface and the second end surface of the central layer 200.

Additionally, due to the elasticity of the central layer 200, when the substrate 1110 undergoes bending, for example, bending toward a side of the second film layer 300, the first film layer 100, the second film layer 300, and the central layer 200 undergo bending deformation synchronously. The first film layer 100 is on an inner side during bending, and therefore the first film layer 100 experiences compressive force. The second film layer 300 is on an outer side during bending, and therefore the second film layer 300 experiences tensile force. The central layer 200, located between the first film layer 100 and the second film layer 300, undergoes elastic deformation due to bending, and therefore the central layer 200 may serve as a neutral layer to counteract part of the compressive force on the first film layer 100 and part of the tensile force on the second film layer 300. This reduces stress experienced by the first film layer 100 and the second film layer 300 during bending, thereby improving bending resistance of the first film layer 100 and the second film layer 300, and further improving bending resistance of the substrate 1110.

Refer to FIG. 7. In some embodiments, the central layer 200 is provided on a penetrating hole, where the penetrating hole is in communication with the through-hole 110.

It can be understood that the penetrating hole is a hole structure penetrating the central layer 200 in a thickness direction. The penetrating hole is in communication with the through-hole 110, specifically, the portion of the penetrating hole may be in communication with the portion of the through-hole 110, or the penetrating hole may be aligned with the through-hole 110, or an opening end of the penetrating hole encompasses an opening end of the through-hole 110, or an opening end of the through-hole 110 encompasses an opening end of the penetrating hole.

Additionally, at least some of the through-holes 110 are in communication with the penetrating holes, that is, a quantity of penetrating holes may be less than a quantity of through-holes 110, with only some of the through-holes 110 in communication with corresponding penetrating holes. Alternatively, a quantity of penetrating holes may be equal to or greater than a quantity of through-holes 110, with each through-hole 110 in communication with at least one penetrating hole.

With such configuration, the penetrating hole is provided on the central layer 200 to reduce an area of the central layer 200 exposed to the first film layer 100 through the through-hole 110, thereby reducing the impact on the optical transparency of the central layer 200 caused by dust passing through the through-hole 110 and accumulating on the central layer 200.

Refer to FIG. 7. In some embodiments, the penetrating hole is aligned with the through-hole 110.

The penetrating hole being aligned with the through-hole 110 means that each through-hole 110 has a corresponding penetrating hole, and the penetrating hole is aligned with the through-hole 110, preventing the central layer 200 from being exposed through the through-hole 110 to an outer side of the first film layer 100.

With such configuration, the penetrating hole aligned with the through-hole 110 is provided on the central layer 200 to prevent the central layer 200 from being exposed to the first film layer 100 through the through-hole 110, thereby reducing the impact on the optical transparency of the central layer 200 caused by dust passing through the through-hole 110 and accumulating on the central layer 200.

Refer to FIG. 7. In some embodiments, the central layer 200 is a clear adhesive layer.

It can be understood that the clear adhesive layer, also referred to as an optical clear adhesive (Optical clear adhesive, OCA) layer, is a flexible polymeric viscoelastic material. Thus, the first film layer 100 may be attached to a first end surface of the optical clear adhesive layer, and the second film layer 300 may be attached to a second end surface of the optical clear adhesive layer, achieving secure attachment of the first film layer 100 and the second film layer 300. Additionally, when bent, the flexible optical clear adhesive layer undergoes significant deformation, and when unbent, the deformation is recoverable.

With such configuration, the optical clear adhesive layer serves as a neutral layer for the first film layer 100 and the second film layer 300. When the substrate 1110 undergoes bending, the optical clear adhesive layer can counteract part of the stress on the first film layer 100 and the second film layer 300, thereby improving bending resistance of the substrate 1110.

Refer to FIG. 1 and FIG. 7. In some embodiments, the first film layer 100 is a plastic film layer.

It can be understood that the plastic film layer may be, but is not limited to, a layer made of a material such as polyethylene terephthalate, polyethylene naphthalate, or polyimide. A plastic film layer made of these materials provides strong support for the first film layer 100 to support the transparent electrode layer 1111, and also exhibits good optical transparency.

Refer to FIG. 1 and FIG. 7. In some embodiments, the second film layer 300 is a plastic film layer.

Similarly, the plastic film layer may be, but is not limited to, a layer made of a material such as polyethylene terephthalate, polyethylene naphthalate, or polyimide. A plastic film layer made of these materials provides strong support and also exhibits good optical transparency.

For example, in some specific implementations, both the first film layer 100 and the second film layer 300 may be plastic film layers made of polyethylene terephthalate, and the central layer 200 may be an optical clear adhesive layer. Thus, the three-layer structure of the substrate 1110 may be: polyethylene terephthalate, optical clear adhesive, and polyethylene terephthalate.

In a specific production process, a first end surface of the optical clear adhesive layer is first attached to the first film layer 100 to form an integral structure. Then, the optical clear adhesive layer and the first film layer 100 are perforated, so that the formed holes simultaneously penetrate the clear adhesive layer and the first film layer 100. After completing the perforation process, a second end surface of the optical clear adhesive layer is attached to the second film layer 300.

An embodiment of this application further provides a solar cell 1100, where the solar cell 1100 includes the substrate 1110 as described above. The solar cell 1100 may be any solar cell 1100 described in the above embodiments, for example, may specifically be a perovskite solar cell 1100. This is not repeatedly described herein.

An embodiment of this application further provides a photovoltaic system, where the photovoltaic system includes the solar cell 1100 as described above. The photovoltaic system may be any photovoltaic system described in the above embodiments, such as an off-grid photovoltaic power generation system or a grid-connected photovoltaic power generation system. This is not repeatedly described herein.

An embodiment of this application further provides an electric device, where the electric device includes the solar cell 1100 as described above. The electric device may be any electric device described in the above embodiments, such as an electric vehicle or a charger for electronic device. This is not repeatedly described herein.

The above are merely preferred embodiments of this application and are not intended to limit this application. Any modifications, equivalent substitutions, improvements, and the like made within the spirit and principle of this application shall fall within the protection scope of this application.

## Claims

1. A substrate, **characterized by** comprising:
a first film layer, wherein the first film layer is provided with at least one through-hole.

2. The substrate according to claim 1, **characterized in that** the first film layer has a bending axis, and the bending axis passes through at least some of the through-holes.

3. The substrate according to claim 2, **characterized in that** the bending axis passes through each of the through-holes.

4. The substrate according to claim 2 or 3, **characterized in that** the at least one through-hole is symmetrically arranged with respect to the bending axis.

5. The substrate according to claim 3 or 4, **characterized in that** a width of the through-hole decreases in a direction away from the bending axis.

6. The substrate according to claim 1, **characterized in that** the first film layer has a bending axis, and the through-hole is provided on at least one side of the bending axis on the first film layer.

7. The substrate according to claim 6, **characterized in that** the through-holes are sequentially arranged on the first film layer in a direction perpendicular to the bending axis.

8. The substrate according to claim 7, **characterized in that** adjacent through-holes have a spacing therebetween, and the spacing increases in a direction away from the bending axis.

9. The substrate according to claim 6, **characterized in that** the through-holes are provided on two opposite sides of the bending axis on the first film layer, and at least two of the through-holes are symmetrically distributed with respect to the bending axis.

10. The substrate according to any one of claims 7 to 9, **characterized in that** the through-hole is a strip through-hole, and a length direction of the strip through-hole is parallel to an extension direction of the bending axis.

11. The substrate according to any one of claims 1 to 10, **characterized in that** the substrate further comprises a second film layer, and the second film layer is attached to the first film layer.

12. The substrate according to claim 11, **characterized in that** the first film layer is a plastic film layer; and/or the second film layer is a plastic film layer.

13. The substrate according to claim 11, **characterized in that** the substrate further comprises a central layer, the central layer is elastic, the central layer comprises a first end surface and an opposite second end surface, the first film layer is attached to the first end surface, and the second film layer is attached to the second end surface.

14. The substrate according to claim 13, **characterized in that** the central layer is provided with a penetrating hole, and the penetrating hole is in communication with the through-hole.

15. The substrate according to claim 14, **characterized in that** the penetrating hole is aligned with the through-hole.

16. The substrate according to claim 13, **characterized in that** the central layer is a clear adhesive layer.

17. A solar cell, **characterized by** comprising the substrate according to any one of claims 1 to 16.

18. A photovoltaic system, **characterized by** comprising the solar cell according to claim 17.

19. An electric device, **characterized by** comprising the solar cell according to claim 17.
